(19) Europäisches Patentamt
European Patent Office
Office européen des brevets

(11) EP 0 391 379 B1

## (12) EUROPEAN PATENT SPECIFICATION

(45) Date of publication and mention
of the grant of the patent:
**10.09.1997 Bulletin 1997/37**

(51) Int Cl.⁶: **H03K 19/177**

(21) Application number: **90106416.2**

(22) Date of filing: **04.04.1990**

(54) **Programmable logic array circuit**

Schaltung einer programmierbaren logischen Anordnung

Circuit d'un réseau logique programmable

(84) Designated Contracting States:
**DE FR GB**

(30) Priority: **06.04.1989 JP 40748/89 U**

(43) Date of publication of application:
**10.10.1990 Bulletin 1990/41**

(73) Proprietor: **Oki Electric Industry Co., Ltd.**
**Tokyo (JP)**

(72) Inventor: **Tanagawa, Kouji,**
**c/o Oki Electirc Industry Co.,Ltd**
**Tokyo (JP)**

(74) Representative: **Betten & Resch**
**Reichenbachstrasse 19**
**80469 München (DE)**

(56) References cited:
**EP-A- 0 282 370**       **WO-A-84/02408**
**GB-A- 2 138 189**       **US-A- 4 659 948**
**US-A- 4 687 959**

- PATENT ABSTRACTS OF JAPAN vol. 13, no. 103 (E-725)(3451), 10 March 1989; & JP - A - 63276327
- PATENT ABSTRACTS OF JAPAN vol. 8, no. 81 (E-238)(1518), 13 April 1984; & JP - A - 592438

## Description

### BACKGROUND OF THE INVENTION

1. Field of the Invention:

The present invention relates to a programmable logic array (PLA) circuit and more particularly to a PLA circuit suitable for control circuits such as microcomputers, microprocessors and digital signal processors.

2. Description of Prior Art:

A programmable logic array is a general-purpose logic structure consisting of an array of logic circuits. The way in which these circuits are programmed determines how input signals to the PLA are processed. For example, the PLA is incorporated in a one-chip microcomputer to decode instructions and to produce control signals to various internal circuits.

Conventionally, such a PLA circuit, for example, is disclosed in Japanese Patents Publication, (KOKAI) No. 59-100627 (Reference 1) and (KOKAI) No. 60-223326 (Reference 2).

The reference 1 discloses that a dynamic PLA circuit includes at least two serially connected transistor groups and performs a pre-charging/pull-down operation in synchronism with a clock signal. In each of the transistor groups, transistors have the conductive paths connected in parallel and control gates each connected to a data input line of each row. These transistor groups have a node which is prechargable during operation and an AND arithmetic result is output from one ends of the serially connected transistor groups when the other ends of the transistor groups are pulled-down at least to a low voltage at prescribed intervals during operation.

The reference 2 discloses a PLA circuit in a partial dynamic structure which is constructed with an AND-OR plane. In the PLA circuit, an output from the AND plane is input during precharge of the OR plane and then an output from the OR plane is read out as a PLA output during precharge of the AND plane. In this manner, the circuit is structurally simplified by precharging alternately the OR and AND planes.

However, the prior art PLA circuit has the following disadvantages.

In the art seen in the reference 1, the PLA circuit has a disadvantage that an PLA output cannot be obtained during its precharge duration.

Also, the PLA circuit seen in the reference 2 cannot provide a PLA output during the precharge of the OR plane. This means that the prior art PLA circuits cannot utilize effectively and arbitrarily PLA output during the entire precharging period. This shortcoming lowers the timing speed of a control circuit with the PLA circuit and results in both low operational speed of instructions and low throughputs.

US-4,687,959 discloses a method and an apparatus for access to a PLA in which improved access to programmable logic arrays is provided by continuously asserting and negating a latch input control signal, continuously asserting and negating a control signal which discharges a first logic section of the array to provide frequent, current inputs to a second logic section of the PLA and discharging the second section of the PLA only upon receipt of an access request. The PLA thereby comprises an AND section, an OR section, and output latches, whereby the OR section and the output latches are controlled in common by a single signal.

US-4,659,948 discloses a single plane programmable logic array using dynamic CMOS logic which has switching transistors located at specific locations within a row-column matrix. The transistors within a column are serially connected and have their gates commonly connected in rows. PMOS and NMOS control transistors conduct exclusively to connect output and input ends of the columns respectively to logic 1 or logic 0 in successive phases of a common clock. Control inputs are applied to specific rows. By applying data inputs to column input ends and into connecting all the column output ends, the PLA is configured to function as a multiplexer. By setting the input end of columns at logic 0 and selectively interconnecting ouput ends of the columns, the PLA is configured to perform other combinational logic functions. While a wired OR circuit is disclosed as a part of PLA, nothing is mentioned about latching, timing, or the respective signals for performing such functions.

JP-A-63-276327 discloses a dynamic logic array to realize the operation from a high speed to a low speed by providing a latch circuit fetching an output signal from an OR array by a low frequency clock signal to form a substantial output signal of an OR array to an output of OR array. The OR array receives an output signal from an AND array at its input to form an output signal including at least an input signal fed to the input of the AND array. An output signal from the OR array is fetched by using a clock signal having a frequency of the operation clock signal or a frequency being on over an integral number thereto thereby forming the substantial output signal of the OR array in the latch circuit provided to the output of the OR array.

### SUMMARY OF THE INVENTION

Accordingly, in order to overcome the problems, it is an object of the present invention to provide a PLA circuit which can provide PLA output all over the precharging period.

Another object of the present invention is to provide a PLA circuit suitable for use in semiconductor integrated digital circuits.

Still another object of the present invention is to provide a PLA circuit suitable for use in microcomputers.

A PLA circuit according to the present invention is disclosed in claim 1. Claims 2 to 7 disclose further embodiments of the present invention.

One embodiment of a PLA circuit comprises means for decoding a prescribed signal after a first precharge timing; means for latching the signal from the decoder means immediately before a second precharge timing; and gate circuit means for controlling a passage of an output of the latching means therethrough with a prescribed timing.

Another embodiment of a programmable logic array system comprises decoding means having a plurality of input lines and a plurality of output lines, the decoding means for decoding an instruction from an instruction register to select a specific one of the plurality of output lines during a first precharging prior and for performing a logical operation between the specific output line and a timing signal from a timing and control circuit during the first timing period; a wired logical circuit connected to the plurality of the output lines of the decoding means; a plurality of sense amplifying means each connected to one of the plurality of output lines of the decoding means for amplifying an output from the wired logical circuit; a plurality of latching means respectively connected to the plurality of sense amplifiers for latching an output from the decoding means immediately before a second precharging operation; and a plurality of logical circuits connected to the latching means by a prescribed timing signal.

According to one embodiment of a PLA circuit, a decoder decodes signals needed during a precharging period before a precharging period. The output of the decoder is latched at a timing immediately before the precharging and then the output of the latch circuit is performed in a logical operation with a predetermined timing signal during a precharging period by a gate circuit to provide the result as a PLA output.

## BRIEF DESCRIPTION OF THE DRAWINGS

Fig. 1 is a block diagram showing digital circuit system including a PLA circuit according to an embodiment of the present invention.

Fig. 2 is a circuit diagram showing a PLA circuit according to an embodiment of the present invention.

Fig. 3 is a timing chart for the PLA circuit shown in Fig. 2.

## DESCRIPTION OF THE PREFERRED EMBODIMENT

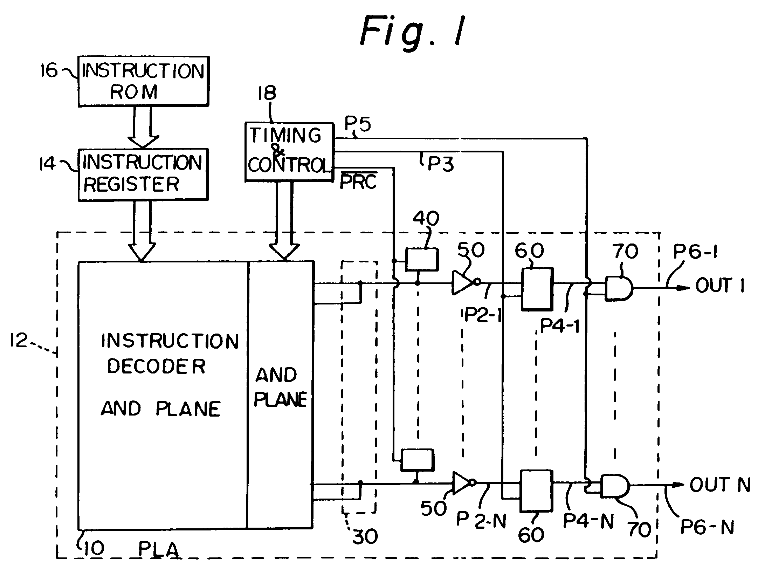

Fig. 1 is a block diagram showing a digital circuit system such as a microcomputer including a PLA circuit according to a preferred embodiment of the present invention. In Fig. 1, the system comprises a PLA circuit 12, an instruction register 14, an instruction read-only memory (ROM) 16 and a timing and control (T&C) circuit 18. The instruction ROM 16 stores instructions and produces them to an instruction register in response to a control signal. The instruction register 14 stores temporary instruction data from the instruction ROM 16. The T&C circuit 18 produces timing signals to the PLA circuit 12. The circuit 18 also produces a precharge signal $\overline{PRC}$, a latching signal $P_3$, and an output control timing signal $P_5$. The PLA circuit 12 includes an instruction decoder 10 and a wired OR circuit 30. The instruction decoder 10 comprises a first AND section which decodes an instruction from the instruction register 14 to select a specific output line and a second AND section which performs an AND operation between the specific output line and a timing signals from the T/C circuit 18 to transfer a signal necessary for instruction execution to the sense amplifier 50.

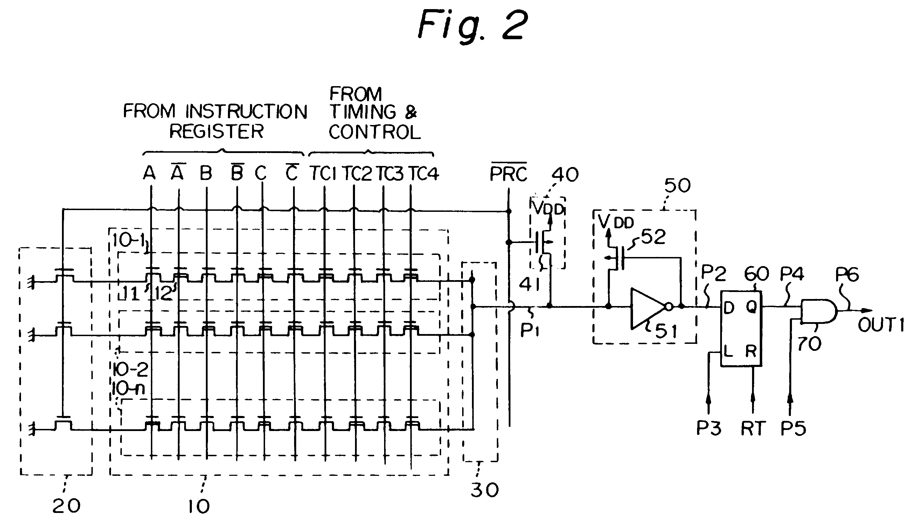

Fig. 2 is a detailed circuit diagram showing a PLA circuit according to a preferred embodiment of the present invention.

PLA circuits are generally used in a microcomputer or the related device. The PLA circuit includes a plurality of decoders 10-1, 10-2 ..., and 10-n each of which decodes a plurality of complementary input signals A, $\overline{A}$, B, $\overline{B}$, C, $\overline{C}$ as an instruction code. Each of the plurality of decoders 10-1, 10-2, ..., and 10-N comprises an NAND circuit which consists of enhancement type MOS transistors 11 and depletion type MOS transistors 12 serially connected to one another. A precharge circuit 20, which is formed of a plurality of N-channel MOS ransistors at one ends of the decoders 10-1, 10-2, ..., and 10-N, with the gates of the N channel MOS transistors being connected commonly to a precharge signal $\overline{PRC}$. The other ends (or outputs) of the decoders 10-1, 10-2 , and 10-N are connected to a wired OR circuit 30. The wired OR circuit 30 has an output P1 connected to the precharge circuit 40 and the sense amplifier 50. The precharge circuit 40 is formed of a P-channel MOS transistor 41 with a gate connected to the precharging signal $\overline{PRC}$. The sense amplifier 50 consists of an inverter 51 which amplifies and inverts the output P1 of the wired OR circuit 30, and a P-channel MOS transistor 52 for waveform shaping which performs a positive feedback operation of the output P2 of the inverter 51. The latching circuit 60 has an input terminal D connected to the output P2 of the sense amplifier 50, a clock terminal L receiving a timing signal P3, a reset terminal R receiving a reset signal R, and an output terminal Q. The latching circuit 60 may be a D-type flip-flop. A two input AND gate circuit 70 receives the output P4 of the output terminal Q and a timing signal P5, and provides the output P6 as an output of the PLA circuit.

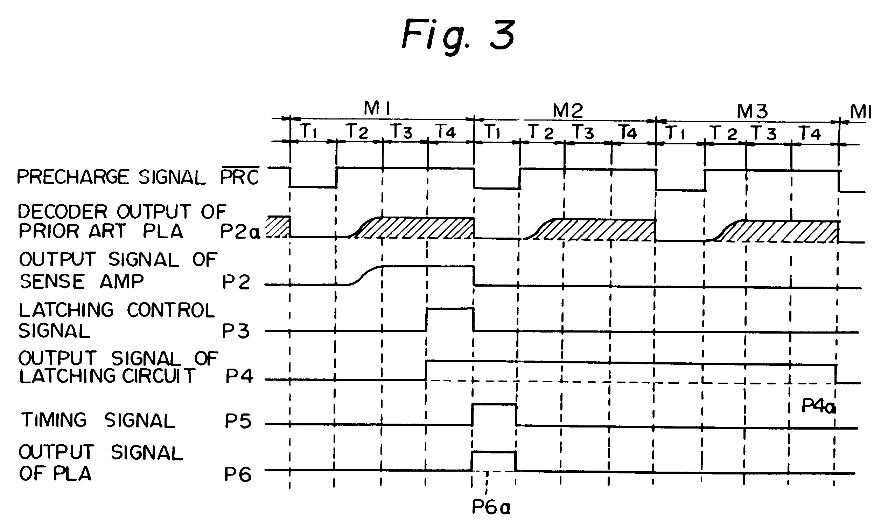

Fig. 3 is a timing chart for performing an instruction execution of the PLA circuit seen in Fig. 1. An operation of the PLA circuit in Fig. 1 will be explained with reference to Fig. 2.

In Fig. 3, for example, the machine cycles M1 through M3 are used for executing an instruction with a microcomputer including a PLA circuit according to a preferred embodiment of the present invention. Each of the machine cycles M1 to M3 is formed of four state timings T1 to T4.

Generally, in the machine cycle (or a first precharging period) M1, the period of the state timings T1 to T2 is a fetch period of instruction to define the instruction code A, $\overline{A}$, B, $\overline{B}$, and C, $\overline{C}$ seen in Fig. 2. In the PLA circuit, the precharging operation of is performed in the timings T1 of the machine cycle MI. A reset signal RT is applied to the latching circuit 60 within the timings T1 of the machine cycle M1. The timings T3 and T4 of the machine cycle M1 is an instruction execution period during which an output P6 which is obtained by decoding the instruction code A, $\overline{A}$, ... C, and $\overline{C}$ latched is used. The timing signal P3 is supplied during the timing T4 of the machine cycle M1. The timings T1 and T2 of the machine cycle (a second precharging period) M2 is a period that the instruction code A to C changes again to modify instruction and the second byte of the instruction. For this reason, a reprecharge operation is performed in this period. A timing signal P5 is supplied at the timing T1 of the machine cycle M2. The timings T3 and T4 of the machine cycle M2 is a period for an instruction execution based on an instruction code A, $\overline{A}$, ...C, $\overline{C}$ which is defined in the timings T1 and T2 of the machine cycle M2. The above described manner is applicable for the machine cycle M3.

With reference to the timing chart of Fig. 3, the case will be described that a PLA output P6 is obtained in a precharing period which is the state timing T1 of a machine cycle M2.

First, when precharging signal $\overline{PRC}$ becomes an L level at the state timing T1 of the machine cycle M1, the precharging circuit 20 is on, while the precharging circuit 40 is off, so that the output of the wired OR circuit 30 is precharged to a power source potential Vdd. In the machine cycle M1, an instruction code A, $\overline{A}$, ... and C, $\overline{C}$ is decoded by the decoders 10-1, 10-2, ..., 10-N. In this case, the decoders 10-1, 10-2, ..., and 10-N can be decoded with respect to any input combination by properly combining the enhancement MOS transistors 11 and the depletion MOS transistors 12. Hence the precharging signal $\overline{PRC}$ is at a H level, so that the precharging circuit 20 becomes on , while the precharging circuit 40 becomes off. Therefore a precharging operation finishes so that the output of the wired OR circuit 30 is decreased to a ground potential. Then in the sense amplifier 50, the inverter 51 inverts the output at the node P1 and provides an output P2 in a H level. When the latching circuit 60 latches the output P2 in response to a timing signal P3 at the timing T4 of the machine cycle M1, it provides an output P4 in a H level. Next, in the machine cycle M2, when the timing signal P5 is a H level at the state timing T1 for a precharging period, the AND gate 70 opens to transmit the output P6 in the state timing T1. In the same manner described above, the PLA output P6 is obtained at the timing T2 of the machine cycle M2, at the timing T1 of the machine cycle M3, and at the timing T2 of the machine cycle M3.

When the instruction decoder 10 does not decode an instruction from the instruction register 14, the latching circuit 60 produces an output signal P4a in an low level, so that the AND gate 70 produces an output P6a in an low level, as shown in Fig. 3.

The present embodiment has the following advantages.

In a prior art PLA circuit, the PLA output can not be utilized during a precharging period because the output P2 of the sense amplifier 50 becomes an L level during precharging operation, as shown by the output waveform P2a of Fig. 3 so that the output P2a of the sense amplifier 50 is fixed at an L level. On the contrary, according to a PLA circuit of the present invention, the decoders 10-1, 10-2, ... and 10-N are constructed so as to provide a PLA output P6 during a precharging operation in the timing T1 or T2 of the machine cycle M2 or in the timing T1 or T2 of the machine cycle M3, for example, in the timing T4 of the machine cycle M2. Also, in the PLA circuit, the latching circuit 6C latches the output at the node P1 through the sense amplifier 50, and the AND logic circuit 70 carries out a logical product of the latched output and a timing signal P5, so that the PLA output P6 is obtained in the timing T1 of the machine cycle M2. As a result, the PLA output P6 can be obtained even during a precharging operation in the period M2 (T1 and T2) or M3(T1 and T2). This feature enables the realization of a PLA circuit with no timing loss suitable for the control circuit for a microcomputer, thus improving an execution speed of instruction and throughput.

The present invention should not be limited to the embodiment shown in Figs. 1 and 2. The embodiment as described before may be modified as follows:

(a) The NAND circuit may be constructed of an AND gate with an inverter.
(b) The gate circuit may be a gate of another type such as an NAND gate.

The PLA circuit according to the present invention is also applicable for other digital apparatus.

As described above in detail, the PLA circuit according the present invention can provide during a precharging period by arranging a new connection of decoder, latching circuit and a gate circuit. Therefore, the PLA circuit can provide an effective timing as a control circuit for a microcomputer and improves execution speed of instruction and throughput.

**Claims**

1. A programmable logic array circuit comprising:

an AND plane (10) for decoding instruction signals (A, $\overline{A}$, B, $\overline{B}$, C, $\overline{C}$) in response to at least one of first timing signals (TC1, TC2, TC3, TC4), the AND plane (10) including a plurality of decode lines (10-1, 10-2, ...10-n) each having serially connected transistors (11, 12);
a wired OR circuit (30) electrically connecting one ends of the decode lines (10-1, 10-2, ... 10-n) with each other to form a common output line (P1);

a precharge circuit (40) for charging said common output line (P1) in response to a precharge signal ($\overline{PRC}$) at the predetermined timing (T1) in every machine cycle (M1 to M3); and

a latch circuit (60) coupled to said common output line (P1) for latching received data in response to a second timing signal (P3) which is different from said precharge signal ($\overline{PRC}$), said latch circuit (60) latching the received data in the first machine cycle (M1). whereby said latch (60) can output a latched signal when said charge circuit (40) charges said common output line (P1) at the predetermined timing (T1) in the second or later machine cycles (M2, M3).

2. A programmable logic array circuit according to claim 1, further comprising a further precharge circuit (20) coupled to the other ends of the decode lines (10-1, 10-2 ...10-n) for preventing discharging of the decode lines (10-1, 10-2, ...10-n) in response to said precharge signal ($\overline{PRC}$).

3. A programmable logic array circuit according to claim 2, wherein the further precharging circuit (20) has a plurality of transistors each of which is connected between ground and one of the other ends of the decode lines (10-1, 10-2, ...10-n), respectively.

4. A programmable logic array circuit according to claim 1, wherein the serially connected transistors (11, 12) have a first group of transistors each of which has a gate receiving one of the instructions signals (A, $\overline{A}$, B, $\overline{B}$, C, $\overline{C}$) and a second group of transistors each of which has a gate receiving the first timing signals (TC1, TC2, TC3, TC4).

5. A programmable logic array circuit according to claim 1, further comprising a sense amplifier (50) coupled to said common output line (P1) for amplifiying the data on said common output line (P1).

6. A programmable logic array circuit according to claim 5, wherein the sense amplifier (50) comprises an inverter (51) having an input coupled to said common output line (P1), and an output and a transistor (S2) having a first terminal coupled to said common output line (P1), a second terminal coupled to a power supply voltage source and a gate coupled to said output of the inverter (51).

7. A programmable logic array circuit according to claim 1, wherein said latch circuit (60) comprises a D-type flip flop.

**Patentansprüche**

1. Programmierbare Logikanordnung, die folgendes aufweist:

eine UND-Ebene (10) zum Decodieren von Befehlssignalen (A, $\overline{A}$, B, $\overline{B}$, C, $\overline{C}$) in Reaktion auf mindestens eines von ersten Taktsignalen (TC1, TC2, TC3, TC4), wobei die UND-Ebene (10) eine Vielzahl von Decodierleitungen (10-1, 10-2, ...10-n) aufweist, von denen jede in Reihe geschaltete Transistoren (11, 12) aufweist; eine verdrahtete ODER-Schaltung (30), die die einen Enden der Decodierleitungen (10-1, 10-2 ...10-n) elektrisch miteinander verbindet, um eine gemeinsame Ausgangsleitung (P1) zu bilden; eine Ladeschaltung (precharge circuit) (40) zum Aufladen der gemeinsamen Ausgangsleitung (P1) in Reaktion auf ein Ladesignal ($\overline{PRC}$) im vorherbestimmten Takt (T1) in jedem Maschinenzyklus (M1 bis M3); und eine Latch-Schaltung (60), die an die gemeinsame Ausgangsleitung (P1) angeschlossen ist, um empfangene Daten in Reaktion auf ein zweites Taktsignal (P3), das sich vom Ladesignal ($\overline{PRC}$) unterscheidet, zu latchen, wobei die Latch-Schaltung (60) die empfangenen Daten im ersten Maschinenzyklus (M1) latcht, wobei die Latch-Schaltung (60) ein gelatchtes Signal ausgeben kann, wenn die Ladeschaltung (40) die gemeinsame Ausgangsleitung (P1) im vorherbestimmten Takt (T1) im zweiten oder in den späteren Maschinenzyklen (M2, M3) lädt.

2. Programmierbare Logikanordnung gemäß Anspruch 1, die weiterhin aufweist:

eine weitere Ladeschaltung (20), die an die anderen Enden der Decodierleitungen (10-1, 10-2, ... 10-n) angeschlossen ist, um das Entladen der Decodierleitungen (10-1, 10-2, ... 10-n) in Reaktion auf das Ladesignal ($\overline{PRC}$) zu verhindern.

3. Programmierbare Logikanordnung gemäß Anspruch 2, bei der die weitere Ladeschaltung (20) eine Vielzahl von Transistoren aufweist, von denen jeder jeweils zwischen Erde und einem der anderen Enden der Decodierleitungen (10-1, 10-2, ... 10-n) angeschlossen ist.

4. Programmierbare Logikanordnung gemäß Anspruch 1, bei der die in Reihe geschalteten Transistoren (11, 12) eine erste Gruppe von Transistoren aufweisen, von denen jeder ein Gate aufweist, das eines der Befehlssignale (A, $\overline{A}$, B, $\overline{B}$, C, $\overline{C}$) empfängt und eine zweite Gruppe von Transistoren, von denen jeder ein Gate aufweist, das die ersten Taktsignale (TC1, TC2, TC3, TC4) empfängt.

**5.** Programmierbare Logikanordnung gemäß Anspruch 1, die weiterhin aufweist:

einen Leseverstärker (50), der an die gemeinsame Ausgangsleitung (P1) angeschlossen ist. um die Daten auf der gemeinsamen Ausgangsleitung (P1) zu verstärken.

**6.** Programmierbare Logikanordnung gemäß Anspruch 5, bei der der Leseverstärker (50) folgendes aufweist:

einen Inverter (51), der einen Eingang, der an die gemeinsame Ausgangsleitung (P1) angeschlossen ist, und einen Ausgang aufweist, ferner einen Transistor (52), der eine erste Anschlußeinheit aufweist, die an die gemeinsame Ausgangsleitung (P1) angeschlossen ist, eine zweite Anschlußeinheit, die an eine Spannungsquelle angeschlossen ist, und ein Gate, das an den Ausgang des Inverters (51) angeschlossen ist.

**7.** Programmierbare Logikanordnung gemäß Anspruch 1, bei der die Latch-Schaltung (60) ein D-Typ Flip-Flop aufweist.

**Revendications**

**1.** Circuit de matrice logique programmable comprenant :

un plan ET (10) destiné à décoder des signaux d'instruction (A, $\overline{A}$, B, $\overline{B}$, C, $\overline{C}$) en réponse à au moins l'un de premiers signaux de cadencement (TC1, TC2, TC3, TC4), le plan ET (10) incluant plusieurs lignes de décodage (10-1, 10-2, ... 10-n) comportant chacune des transistors (11, 12) connectés en série ;
un circuit OU câblé (30) reliant électriquement, les unes aux autres, des premières extrémités des lignes de décodage (10-1, 10-2, ... 10-n) pour former une ligne de sortie (P1) commune ;
un circuit (40) de précharge pour charger ladite ligne de sortie (P1) commune en réponse à un signal ($\overline{PRC}$) de précharge à un cadencement prédéterminé (T1) dans chaque cycle machine (M1 à M3) ; et
un circuit verrou (60) raccordé à ladite ligne de sortie (P1) commune pour verrouiller la donnée reçue en réponse à un deuxième signal de cadencement (P3) qui est différent dudit signal ($\overline{PRC}$) de précharge, ledit circuit verrou (60) verrouillant la donnée reçue dans le premier cycle machine (M1), en permettant ainsi audit verrou (60) de sortir un signal verrouillé lorsque ledit circuit de charge (40) charge ladite ligne de sortie (P1) commune au cadencement (T1) prédéterminé dans le deuxième cycle machine ou un cycle ultérieur (M2, M3).

**2.** Circuit de matrice logique programmable selon la revendication 1, comprenant en outre un circuit (20) de précharge supplémentaire raccordé aux autres extrémités des lignes de décodage (10-1, 10-2, ... 10-n) pour prévenir la décharge des lignes de décodage (10-1, 10-2, ... 10-n) en réponse audit signal de précharge ($\overline{PRC}$).

**3.** Circuit de matrice logique programmable selon la revendication 2, dans lequel le circuit (20) de précharge supplémentaire comporte plusieurs transistors dont chacun est connecté, respectivement, entre la masse et l'une des autres extrémités des lignes de décodage (10-1, 10-2, ... 10-n).

**4.** Circuit de matrice logique programmable selon la revendication 1, dans lequel les transistors (11, 12) connectés en série comportent un premier groupe de transistors dont chacun a une grille recevant l'un des signaux d'instruction (A, $\overline{A}$, B, $\overline{B}$, C, $\overline{C}$) et un second groupe de transistors dont chacun a une grille recevant les premiers signaux de cadencement (TC1, TC2, TC3, TC4).

**5.** Circuit de matrice logique programmable selon la revendication 1, comprenant en outre un amplificateur de lecture (50), raccordé à ladite ligne de sortie (P1) commune, destiné à amplifier la donnée sur ladite ligne de sortie (P1) commune.

**6.** Circuit de matrice logique programmable selon la revendication 5, dans lequel l'amplificateur de lecture (50) comprend un inverseur (51) ayant une entrée, raccordée à ladite ligne de sortie (P1) commune, et une sortie, et un transistor (52) ayant une première borne raccordée à ladite ligne de sortie (P1) commune, une seconde borne raccordée à une source de tension d'alimentation, et une grille raccordée à ladite sortie de l'inverseur (51).

**7.** Circuit de matrice logique programmable selon la revendication 1, dans lequel ledit circuit verrou (60) comprend une bascule de type D.

## Fig. 1

INSTRUCTION ROM  16

INSTRUCTION REGISTER  14

TIMING & CONTROL  18

P5

P3

PRC

40

50

60

70

INSTRUCTION DECODER AND PLANE

AND PLANE

12

P2-1

P4-1

P6-1

OUT 1

50

P 2-N

60

P4-N

70

OUT N

P6-N

30

10   PLA

EP 0 391 379 B1

Fig. 2

EP 0 391 379 B1

Fig. 3